Europäisches Patentamt

European Patent Office

Office européen des brevets

(11) Veröffentlichungsnummer: **0 443 055 A1**

## EUROPÄISCHE PATENTANMELDUNG

(21) Anmeldenummer: 90103269.8

(22) Anmeldetag: **20.02.90**

(51) Int. Cl.⁵: **H01L 27/02**

(43) Veröffentlichungstag der Anmeldung:
**28.08.91 Patentblatt 91/35**

(84) Benannte Vertragsstaaten:
**DE FR GB IT NL**

(71) Anmelder: **Siemens Aktiengesellschaft**
**Wittelsbacherplatz 2**
**W-8000 München 2(DE)**

(72) Erfinder: **Becker, Burkhard, Dr.**
**Schlüsselbergstrasse 8**
**W-8000 München 80(DE)**

(54) **Eingangsschutzstruktur für integrierte Schaltungen.**

(57) Die vorgeschlagene Eingangsschutzstruktur für integrierte Schaltungen enthält mindestens einen Eingangstransistor (3), einen Ansteuertransistor (4) und einen integrierten Widerstand (16b, 17b), über den die Basis (16a, 17a) des Ansteuertransistors (4) an ein Referenzpotential (2) anschließbar ist. Der Emitter (15) des Eingangstransistors (3) ist mit dem Eingang (1), der Emitter (18, 19) des Ansteuertransistors (4) ist mit der Basis (14) des Eingangstransistors (3) verbunden und die Kollektoren (11, 12a) der beiden Transistoren sind an ein Versorgungspotential (5) anschließbar. Durch die auf diese Weise gebildete Darlington-Schaltung wird ein schneller und zuverlässiger Schutz gegen elektrostatische Entladungen beider Polaritäten erzielt.

FIG 1

EP 0 443 055 A1

## EINGANGSSCHUTZSTRUKTUR FÜR INTEGRIERTE SCHALTUNGEN.

Die vorliegende Erfindung betrifft eine Eingangsschutzstruktur für integrierte Schaltungen nach dem Oberbegriff des Patentanspruchs 1.

Integrierte Schaltungen benötigen einen sicheren Schutz gegen elektrostatische Entladungen. Zu diesem Zweck werden sie mit Eingangsschutzstrukturen versehen, einige dem Stand der Technik entsprechende Strukturen sind in der DE-OS 36 16 394 erläutert. Ferner sind Eingangsschutzstrukturen für bipolare integrierte Schaltungen bekannt, die mindestens zwei Transistoren und einen integrierten Widerstand enthalten, beispielsweise aus der DE-OS 32 01 933. Es ist üblich, Transistoren des entgegengesetzten Leitungstyps zu wählen und zu einem Thyristor zu verschalten, um eine gute Schutzwirkung zu erhalten.

Der vorliegenden Erfindung liegt die Aufgabe zugrunde, eine Eingangsschutzstruktur für integrierte Schaltungen anzugeben, die einen schnellen und zuverlässigen Schutz gegen elektrostatische Entladungen beider Polaritäten ermöglicht.

Diese Aufgabe wird bei einer Eingangsschutzstruktur nach dem Oberbegriff des Patentanspruchs 1 erfindungsgemäß durch die Merkmale des kennzeichnenden Teils des Patentanspruchs 1 gelöst. Weiterbildungen der Erfindung sind Gegenstand von Unteransprüchen.

Die Erfindung wird im folgenden anhand von Ausführungsbeispielen gemäß den Figuren 1 bis 4 der Zeichnung näher erläutert. Es zeigt:

FIG 1 - ein Ersatzschaltbild einer Eingangsschutzstruktur mit mindestens zwei Transistoren und einen integrierten Widerstand gemäß der Erfindung, und

FIG 2-4- drei Ausführungsformen der Realisierung einer Eingangsschutzstruktur nach Figur 1 in einem Halbleitersystem in schematischer Darstellung.

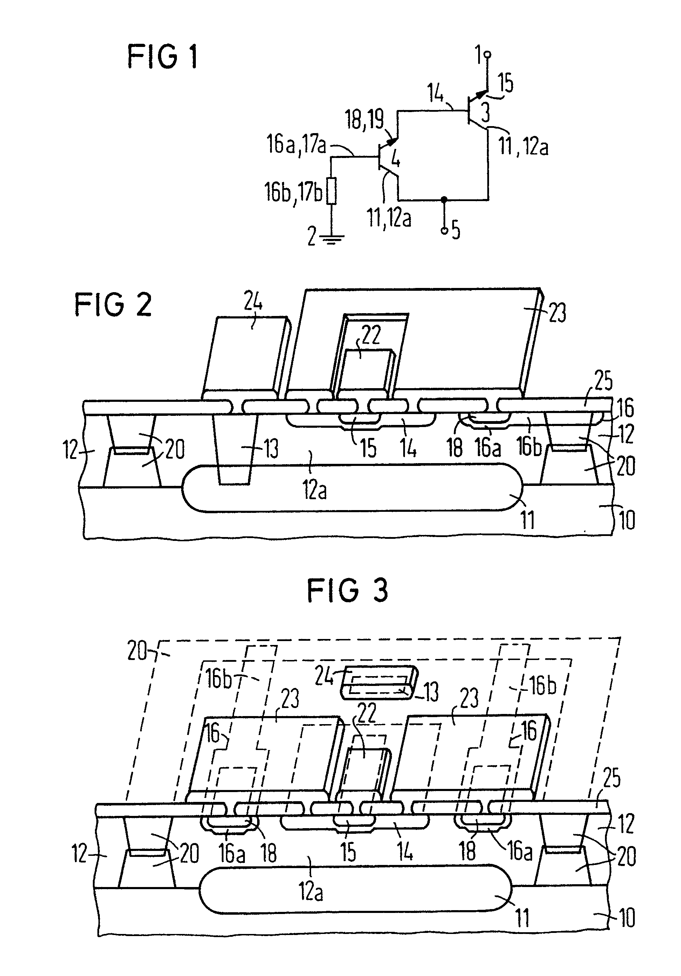

Gemäß Figur 1 liegt zwischen einem Eingangsanschluß 1 einer integrierten Schaltung, insbesondere einer bipolaren integrierten Schaltung, und einem Anschluß für ein Referenzpotential 2, insbesondere einem Masseanschluß, eine Schutzstruktur, die durch einen ersten Transistor 3 als Eingangstransistor, einen zweiten Transistor 4 als Ansteuertransistor und einen integrierten Widerstand 16b, 17b gebildet wird. Der Emitter 18, 19 des zweiten Transistors 4 ist an die Basis 14 des Eingangstransistors 3 angeschlossen, die Kollektoren 11, 12a beider Transistoren sind miteinander verbunden und besitzen einen gemeinsamen Anschluß 5. Eine derartige Kopplung zweier Transistoren stellt eine Darlington-Schaltung dar, wie in dem Buch von U. Tietze, C. Schenk, Halbleiter-Schaltungstechnik, Springer-Verlag 1980, Seite 56 ff beschrieben. Ferner ist der Emitter 15 des Eingangstransistors 3 mit dem Eingangsanschluß 1 und die Basis 16a, 17a des Ansteuertransistors 4 über den integrierten Widerstand 16b, 17b mit dem Referenzpotentialanschluß 2 verbunden. An den gemeinsamen Kollektoranschluß 5 der beiden Transistoren 3, 4 kann ein weiteres Potential, insbesondere Versorgungspotential, angelegt werden.

In den Figuren 2 bis 4 sind drei Ausführungsbeispiele der Realisierung der erfindungsgemäßen Schutzstruktur nach Figur 1 in einem Halbleitersystem dargestellt; dabei wird ein Schnittbild mit zusätzlicher Schrägaufsicht nach hinten verwendet. Bei allen drei Ausführungsformen wird als Grundlage ein Halbleitersubstrat 10 eines ersten Leitungstyps, vorzugsweise des p-Leitungstyps, verwendet, auf welches im Laufe des Herstellverfahrens der Schutzstruktur eine epitaktische Schicht 12 des entgegengesetzten zweiten Leitungstyps, vorzugsweise also des n-Leitungstyps, mit bekannten Methoden aufgebracht wird. Ferner ist allen Ausführungsbeispielen eine vergrabene Zone 11 (buried layer) des zweiten Leitungstyps gemeinsam, die ebenso wie die übrigen dotierten Zonen mittels konventioneller Herstellungsverfahren, wie Implantation mit anschließendem Temperaturschritt, erzeugt werden kann. In den Figuren sind gleiche Teile mit gleichen Bezugsziffern versehen.

Im ersten Ausführungsbeispiel gemäß Figur 2 dient ein in sich geschlossener Isolationsrahmen 20, bestehend aus dotierten Zonen des ersten Leitungstyps, zur Isolation der gesamten Schutzstruktur gegenüber benachbarten Bauelementen. Die vergrabene Zone 11 bildet gemeinsam mit einem vom Isolationsrahmen 20 eingeschlossenen Teilbereich 12a der epitaktischen Schicht 12 den gemeinsamen Kollektor 11, 12a beider Transistoren gemäß Figur 1. Eine hochdotierte Zone 13 des zweiten Leitungstyps dient als gemeinsamer Anschluß. Der Eingangstransistor 3 wird durch eine dotierte Zone 15 des zweiten Leitungstyps als Emitter und eine diese Zone umschließende dotierte Zone 14 des ersten Leitungstyps als Basis vervollständigt. Eine weitere dotierte Zone 16 des ersten Leitungstyps ist in der epitaktischen Schicht 12 so angeordnet, daß sie zum Teil innerhalb des Teilbereichs 12a der epitaktischen Schicht liegt und den Isolationsrahmen 20 teilweise überlappt. Ein Kontakt dieser Zone 16 mit der epitaktischen Schicht 12 außerhalb des Isolationsrahmens 20 ist nicht notwendig. Der innerhalb des Teilbereichs 12a liegende und an den Isolationsrahmen 20 anschließende Teil 16b dieser Zone 16 stellt den integrierten Widerstand gemäß Figur 1 dar. Der verbleibende, vom Isolationsrahmen 20 abgewandte Teil 16a dient als Basis des Ansteuertransistors 4; er umschließt eine weitere dotierte Zone 18 des zweiten Leitungstyps, welche den Emitter des Ansteuertransistors bildet. Basis 14 und Emitter 15 des Eingangstransistors 3 werden durch übliche dotierte Zonen 14, 15 innerhalb des Teilbereichs 12a gebildet. Der Emitter 18 des Ansteuertransistors 4 ist über eine, vorzugsweise metallische, Leitbahn 23 mit der Basis 14 des Eingangstransistors 3 verbunden, wie in der Figur 2 dargestellt. Über eine weitere Leitbahn 22 ist der Emitter 15 des Eingangstransistors 3 mit dem Eingang 1 verbindbar, eine Leitbahn 24 kontaktiert den gemeinsamen Kollektor 11, 12a über die hochdotierte Zone 13 und wird an das Versorgungspotential 5 angeschlossen. Der Anschluß der Basis 16a des Ansteuertransistors 4 über den integrierten Widerstand 16b an das Referenzpotential 2 erfolgt über den Isolationsrahmen 20 und das Halbleitersubstrat 10, welches einen außerhalb der Schutzstruktur befindlichen Masseanschluß besitzt.

Außerhalb der Kontaktbereiche zwischen Leitbahnen und dotierten Zonen ist die Oberfläche von einer isolierenden Schicht 25 bedeckt.

Im zweiten Ausführungsbeispiel gemäß Figur 3 besitzt der Ansteuertransistor 4 zwei getrennte Emitter-Basis-Bereiche 18, 16a, die auf verschiedenen Seiten des Emitter-Basis-Bereichs 15, 14 des Eingangstransistors 3 liegen. Jedes dieser Basis-Gebiete 16a ist wie im ersten Ausführungsbeispiel als Teil einer dotierten Zone 16 ausgebildet, deren übriger Teil den integrierten Widerstand 16b bildet und an den Isolationsrahmen 20 angeschlossen ist. Beide Emitter 18 sind über jeweils eine Leitbahn 23 mit der Basis 14 des Eingangstransistors 3 verbunden. Insgesamt ist eine im wesentlichen symmetrische Anordnung vorteilhaft, wie in Figur 3 dargestellt, bei welcher auch die den gemeinsamen Kollektor 11, 12a anschließende hochdotierte Zone 13 und die sie kontaktierende Leitbahn 24 in etwa symmetrisch zwischen den beiden Emitter-Basis-Bereichen des Ansteuertransistors bzw. zwischen den beiden integrierten Widerständen 16b liegt.

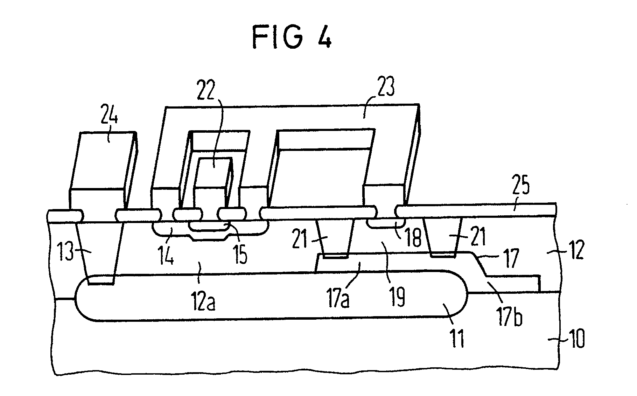

Das dritte Ausführungsbeispiel gemäß Figur 4 unterscheidet sich vom ersten gemäß Figur 2 im wesentlichen durch die Anordnung der den Ansteuertransistor 4 bildenden dotierten Zonen und des integrierten Widerstandes. Der Isolationsrahmen 20 ist nicht dargestellt, da er zum Anschluß des integrierten Widerstandes 17b an das Referenzpotential 2 nicht notwendig ist. Eine untere Diffusionszone 17 liegt jeweils zum Teil auf der vergrabenen Zone 11 und auf dem Halbleitersubstrat 10 auf, so daß sie zu beiden Gebieten Kontakt hat. Die untere Diffusionszone 17 besitzt denselben Leitungstyp wie das Halbleitersubstrat 10. In der epitaktischen Schicht 12 ist eine ringförmige, vorzugsweise stark dotierte Zone 21 des ersten Leitungstyps so angeordnet, daß sie in die untere Diffusionszone 17 hineinreicht und einen Teilbereich 19 der epitaktischen Schicht 12 von der übrigen epitaktischen Schicht 12, 12a isoliert. Dieser Teilbereich 19 bildet gemeinsam mit einer in ihr liegenden, insbesondere hochdotierten Zone 18 des zweiten Leitungstyps den Emitter des Ansteuertransistors 4, die ringförmige Zone 21 dient als Emitterisolation.

Der unterhalb des Emitters 18, 19 liegende Teilbereich 17a der unteren Diffusionszone 17, welcher gleichzeitig auf der vergrabenen Zone 11 aufliegt, stellt die Basis des Ansteuertransistors dar. Der verbleibende Teilbereich 17b der unteren Diffusionszone 17 bildet den integrierten Widerstand, durch seinen Kontakt mit dem Halbleitersubstrat 10 ist er über dieses an das Referenzpotential 2 anschließbar (nicht dargestellt). Der Kollektor des Ansteuertransistors 4 wird durch die vergrabene Zone 11 gebildet, die wie in den vorhergehenden Ausführungsbeispielen über eine hochdotierte Zone 13 des zweiten Leitungstyps und eine Leitbahn 24 an das Versorgungspotential 5 anschließbar ist. Der Aufbau des Eingangstransistors 3 sowie der Anschluß seiner Basis 14 über eine Leitbahn 23 an den Emitter 18, 19 des Ansteuertransistors 4 wird bevorzugt wie im ersten Ausführungsbeispiel ausgeführt.

Der Vorteil der erfindungsgemäßen Eingangsschutzstruktur liegt unabhängig von der speziellen Ausführungsform im Vorhandensein von jeweils zwei Ableitungspfaden für Impulse beider Polaritäten und wird im folgenden anhand der Arbeitsweise der Struktur erläutert.

Bei negativen Spannungen am Eingang 1 sind die Emitter-Basis-Bereiche beider Transistoren 3,4 in Durchlaßrichtung gepolt. Negative Impulse werden daher zum einen über die beiden Emitter-Basis-Übergänge, den integrierten Widerstand 16b, 17b und das Halbleitersubstrat 10 zum Referenzpotential 2 abgeleitet. Zusätzlich werden sie über einen $U_{CEO}$-Durchbruch sowohl des Eingangstransistors 3 als auch des Ansteuertransistors 4 über den Kollektoranschluß 5 abgebaut. Die hohe Stromverstärkung der Darlington-Schaltung sorgt für einen schnellen Abbau der Spannung.

Bei positiven Impulsen am Eingang 1 sind die beiden Emitter-Basis-Übergänge in Sperrichtung gepolt. Die Belastbarkeit der Übergänge wird dadurch erhöht, daß eine frühzeitige gegenseitige Injektion von freien Ladungsträgern in die jeweils andere Sperrschicht über die Leitbahn 23 erfolgt, bevor die Spannung soweit angestiegen ist, daß eine Zerstörung die Folge wäre. Der Ansteuertransistor 4 injiziert im inversen Arbeitsbereich Ladungsträger in die Emitter-Basis-Sperrschicht des Eingangstransistors 3, welche einen frühzeitigen Durchbruch durch die Bildung von Sekundärelektronen ohne Zerstörung der Sperrschicht auslösen. Es wird ein niederohmiger Pfad zum Substrat 10 hin erzeugt, wobei die Durchbruchspannung kleiner sein kann als die Summe der Duchbruchspannungen der einzelnen Gebiete. Nach dem Durchbruch beider Sperrschichten fällt die noch anliegende Spannung an dem integrierten Widerstand 16b, 17b ab, so daß eine weitere Zunahme von sekundären Ladungsträgern und eine Überlastung der Sperrschichten vermieden wird. Ein zweiter Ableitungspfad für positive Impulse ergibt sich über einen $U_{ECO}$-Durchbruch des Eingangstransistors 3. Mit Hilfe einer positiven Vorspannung am Kollektoranschluß 5 wird erreicht, daß Signalspannungen auch mit Werten oberhalb der $U_{ECO}$-Spannung des Eingangstransistors 3 verarbeitet werden können.

Die Reihenschaltung der beiden Emitter-Basis-Bereiche gewährleistet eine Halbierung der Emitter-Basis-Eingangskapazität (FIG 2), wodurch sich die Schutzschaltung auch bei Hochfrequenzanwendungen mit Anforderungen an die maximal zulässige zusätzliche Kapazität eignet. Schutzstrukturen mit einer zusätzlichen Kapazität von wenigen Zehntel pF können so erzeugt werden. Der Flächenbedarf einer derartigen Struktur liegt in der Größenordnung des zweifachen Flächenbedarfs eines Standard-npn-Transistors.

Ein weiterer Vorteil der Schutzstruktur liegt im extrem kleinen Sperrstrom in der Größenordnung von einigen mA selbst bei Temperaturen im Bereich von 150° C. Einen weitgehenden Schutz gegen elektrische Überlastung bietet die Struktur aufgrund ihrer statischen Belastbarkeit im Bereich von mehreren Watt.

Die dritte Ausführungsform der Erfindung gemäß der FIG 4 besitzt eine besonders hohe Durchbruchspannung, wodurch sich der Anwendungsbereich vergrößert. Als vorteilhaft hat sich die Kombination aus Emitter-Basis-Komplex eines üblichen horizontalen Transistors als Eingangstransistor 3 und Emitter-Basis-Komplex eines vertikalen Transistors als Ansteuertransistor 4 erwiesen.

Der Auswahl einer Schutzstruktur muß immer die Art des zu schützenden Bauelements zugrunde gelegt werden. So werden an den Schutz von z.B. lateralen pnp-Transistoren andere Anforderungen gestallt als an den Schutz des Emitter-Basis-Komplexes von Standard-npn-Transistoren, welche aufgrund der Emitter-Krümmung und des lokalen Auftretens von Sperrschichtdurchbrüchen besonders scharfe Anforderungen an eine Schutzstruktur hinsichtlich der Ansprechgeschwindigkeit und Belastbarkeit stellen. Die vorgestellten Schutzstrukturen erfüllen gerade für diesen Fall aufgrund der Art der Ableitungspfade über $U_{CEO}$-Durchbrüche die hier gestellten Anforderungen.

Die Beschaltung der Schutzstruktur kann ohne weiteres in der komplementären Weise vorgenommen werden, wobei die Anschlüsse 1 und 5 vertauscht werden. Die Ableitung von negativen Impulsen erfolgt dabei über die Diode. Positive Impulse werden über einen $U_{CER}$-Durchbruch der Transistoren 3 und 4 abgeleitet. Eine Versorgungsspannung ist hier in der Regel nicht erforderlich.

**Patentansprüche**

1. Eingangsschutzstruktur für integrierte Schaltungen, welche
   - zwischen einen Eingang (1) und einen Anschluß für ein Referenzpotential (2) geschaltet ist,
   - in einem Halbleitersubstrat (10) angeordnet ist,
   - mindestens einen ersten Transistor (3) als Eingangstransistor, einen zweiten Transistor (4) als Ansteuertransistor und einen integrierten Widerstand (16b, 17b) enthält,
   **dadurch gekennzeichnet,** daß die Basis (14) des Eingangstransistors (3) mit dem Emitter (18, 19) des Ansteuertransistors (4) und der Kollektor (11, 12a) des Eingangstransistors (3) mit dem Kollektor (11, 12a) des Ansteuertransistors (4) verbunden ist (Darlington-Schaltung).

2. Eingangsschutzstruktur nach Anspruch 1, **dadurch gekennzeichnet,** daß die Kollektoren (11, 12a) gemeinsam an ein Versorgungspotential (5) anschließbar sind.

3. Eingangsschutzstruktur nach einem der Ansprüche 1 bis 2, **dadurch gekennzeichnet,** daß der Emitter (15) des Eingangstransistors (3) an den Eingang (1) und die Basis (16a, 17a) des Ansteuertransistors (4) über den integrierten Widerstand (16b, 17b) an den Anschluß für das Referenzpotential (2) angeschlossen ist.

4. Eingangsschutzstruktur nach einem der Ansprüche 1 bis 3, **dadurch gekennzeichnet,** daß die Verbindung der Basis (14) des Eingangstransistors (3) mit dem Emitter (18, 19) des Ansteuertransistors (4) über mindestens eine Leitbahn (23) erfolgt.

5. Eingangsschutzstruktur nach einem der Ansprüche 1 bis 4, **dadurch gekennzeichnet,** daß die Basis (16a, 17a) des Ansteuertransistors (4) und der integrierte Widerstand (16b, 17b) von Teilen einer dotierten Zone (16, 17) gebildet werden.

6. Eingangsschutzstruktur nach einem der Ansprüche 1 bis 5, **dadurch gekennzeichnet,** daß die Kollektoren (11, 12a) der beiden Transistoren (3, 4) mindestens durch eine vergrabene Zone (11) gebildet werden.

7. Eingangsschutzstruktur nach einem der Ansprüche 1 bis 6, **dadurch gekennzeichnet,** daß eine untere Diffusionszone (17), welche zum Teil auf der vergrabenen Zone (11) und zum Teil auf dem Halbleitersubstrat (10) aufliegt, die Basis (17a) des Ansteuertransistors (4) und den integrierten Widerstand (17b) bildet.

8. Eingangsschutzsstruktur nach einem der Ansprüche 1 bis 7, **dadurch gekennzeichnet,** daß der Emitter (18, 19) des Ansteuertransistors (4) durch eine dotierte Zone (18) und einen Teil (19) einer auf das Halbleitersubstrat (10) aufgebrachten epitaktischen Schicht (12), welcher von der übrigen epitaktischen Schicht (12) durch einen Emitter-Isolationsring (21) isoliert ist, gebildet wird.

9. Eingangsschutzstruktur nach einem der Ansprüche 1 bis 8, **gekennzeichnet,** durch eine zur Oberfläche des Halbleitersubstrats (10) weitgehend vertikale Anordnung der den Ansteuertransistor (4) bildenden Zonen (19, 18, 17a, 11) und einen im wesentlichen vertikalen Strompfad innerhalb des Ansteuertransistors (4).

10. Eingangsschutzstruktur nach einem der Ansprüche 1 bis 6, **gekennzeichnet,** durch zwei voneinander getrennte Emitter-Basis-Bereiche des Ansteuertransistors (4), welche im wesentlichen symmetrisch zum Emitter-Basis-Bereich des Eingangstransistors (3) liegen.

FIG 1

FIG 2

FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A | GB-A-2019645 (SGS-ATES COMPONENTI)<br>* Seite 2, Zeile 36 - Seite 3, Zeile 77; Figuren *<br><br>----- | 1, 2, 4 | H01L27/02 |
| | | | **RECHERCHIERTE SACHGEBIETE (Int. Cl.5 )**<br><br>H01L |

Der vorliegende Recherchenbericht wurde für alle Patentansprüche erstellt

| Recherchenort | Abschlußdatum der Recherche | Prüfer |
|---|---|---|
| DEN HAAG | 30 JULI 1990 | VENDANGE P. |